# EUROPEAN PATENT APPLICATION

(11) **EP 2 635 004 A1**
(43) Date of publication of application: **04.09.2013**
(21) Application number: 11836134.4
(22) Date of filing: 20.10.2011
(51) Int. Cl.: H04M 1/02, H05K 5/02

(54) **HOUSING FOR PORTABLE ELECTRONIC APPARATUS, PORTABLE ELECTRONIC APPARATUS, AND METHOD FOR ASSEMBLING PORTABLE ELECTRONIC APPARATUS**

(30) Priority: 27.10.2010 JP 2010241213
(71) Applicant: NEC Corporation, Tokyo 108-8001 (JP)
(72) Inventor: SAKAI Takahiro, Tokyo 108-8001 (JP); HOMMA Yasuyuki, Kakegawa-shi Shizuoka 436-8501 (JP)
(74) Representative: Vossius & Partner
(86) International application number: PCT/JP2011/074207
(87) International publication number: WO 2012/056998

(57) **Abstract**

A mobile phone includes a housing (7) formed by an upper housing part and a lower housing part that are integrally structured. At least a part of an upper surface of the housing (7) is made open to form an upper surface opening (11). Inside the housing (7), inner mounted components (a circuit board (8), a key switch board (9), or a battery) are mounted. The upper surface opening (11) of the housing (7) is covered with a key sheet (12). A method for assembling the mobile phone includes inserting the inner mounted components through the upper surface opening (11) into the inside of the housing (7) to be mounted inside the housing (7), and then covering the upper surface opening (11) with the key sheet (12).

## Description

### Technical Field

The present invention relates to a housing for a portable electronic device, a portable electronic device including the housing, and a method for assembling the portable electronic device.

### Background Art

In the present specification, a portable electronic device is a generic name of various types of portable communication devices and personal digital assistants. Concrete examples of the portable electronic devices are a mobile phone, a personal digital assistant, an electronic dictionary, an electronic organizer, an electronic book, a calculator, a portable personal computer, and the like. A housing for the portable electronic device means a strucrural body forming an outer shell of the portable electronic device.

An upper housing part is a part of the housing for the portable electronic device, and this part includes a surface (referred to as an upper surface in the following) that faces a user when the user operates the portable electronic device. Arranged in the upper housing part are generally an operational input device (for example, a keyboard), a display device (for example, a liquid crystal display) or/and the like of the portable electronic device.

A lower housing part is a part of the housing for the portable electronic device, and this part includes a surface (referred to as a bottom surface) that is positioned opposite to the upper surface. In other words, the lower housing part is a part of the housing for the portable electronic device, and this part includes the surface that is positioned on the back side when viewed from a user who operates the portable electronic device.

Conventionally, the upper housing part and the lower housing part are separately molded to be then united to each other to assemble the housing for the portable electronic device. For example, Patent Literature 1 discloses a housing structure of an electronic device that holds mounted components in an inside space formed by engagement of an upper housing and a lower housing.

Patent Literature 2 discloses a housing for a thin communication device structured by two components of a front housing and a rear housing.

### Prior Art Literature

### Patent Literature

Patent Literature 1: Unexamined Japanese Patent Application Kokai Publication No. H08-18640
Patent Literture 2: Unexamined Japanese Patent Application Kokai Publication No. 2009-152789

### Disclosure of the Invention

### Problem to be Solved by the Invention

The housing (referred to as the conventional housing in the following) for the portable electronic device as disclosed in Patent Literature 1 or Patent Literature 2 requires a fastening element (for example, a screw) that fastens the upper housing and the lower housing together. In order to provide the housing with a waterproof structure, it is necessary to sandwitch rubber packing or the like between the upper housing and the lower housing.

Accordingly, the conventional housing has a problem in that the number of the constututing components increases, and the number of assembling process steps increases. The increase in the number of the components and the number of the process steps leads to a rise in manufacturing cost.

In order to secure waterproof property of the housing, the upper housing and the lower housing are required to tightly contact each other in a state where the rubber packing or the like is compressed. For this reason, the number of the fastening elements (screws or the like) increases to further increase the number of the components and the number of the process steps.

In addition, a structure (for example, a groove-shaped structure) for holding the rubber packing or the like is required to be provided in each of the upper housing and the lower housing. There is another problem in that providing such a structure causes an inside volume of the housing to decrease, and causes an outer shape (volume) to increase.

A material of the rubber packing or the like generally tends to degrade more than a material forming the upper housing and the lower housing. Accordingly, the rubber packing or the like is required to be periodically replaced with new rubber paking or the like to maintain waterproof property of the housing.

In view of the above-described background,the present invention has been made, and an object of the present invention is to provide a housing for a portable electronic device, in which the number of components is decreased, a portable electronic device including the housing, and a method for assembling the portable electronic device.

### Means for Solving the Problem

In order to accomplish the above-described object, a housing for a portable electronic device according to a first aspect of the present invention is a housing for a portable electronic device including an upper housing part and a lower housing part, wherein an upper-side bottom surface opening formed in a lower surface of the upper housing part is integrally combined with a lower-side upper surface opening formed in an upper surface of the lower housing part to form the housing.

A portable electronic device according to another aspect of the present invention includes the housing according to the first aspect of the present invention, and an inner mounted component arranged inside the housing.

A portable electronic device according to another aspect of the present invention includes the housing according to the first aspect of the present invention, an outside surface opening that is formed in at least a part of outside surfaces of the housing and through which an inner mounted component is inserted, and a sheet-shaped member that covers the outside surface opening.

A method for assembling a portable electronic device according to another aspect of the present invention includes fitting and integrally combining an upper-side bottom surface opening formed in a lower surface of an upper housing part with a lower-side upper surface opening formed in an upper surface of a lower housing part to form a housing, forming an outside surface opening that opens at least a part of outside surfaces of the housing, inserting an inner mounted component through the outside surface opening into an inside of the housing to mount the inner mounted component, and covering the outside surface opening with a sheet-shaped member.

### Effects of the Invention

According to the present invention, since the upper housing part and the lower housing part are integrally structured, the number of constituting components can be decreased. Accordingly, the number of process steps for manufacturing the housing can be decreased, and the number of process steps for assembling the portable electronic device can be decreased. As a result, manufacturing cost of the housing and the portable electronic device can be reduced.

Since the upper housing part and the lower housing part are integrally structured, the housing can be structured so as to have light weight and high mechanical strength.

It is unnecessary to sandwich rubber packing or the like between the upper housing part and the lower housing part. Accordingly, it is possible to remove the burden of replacing the rubber packing or the like degraded because of time elapsing, with new rubber packing or the like.

It is unnecessary to provide a structure for holding the rubber packing inside the housing, and therefore an outer shape of the housing can be made smaller-sized. Further, since a mold for molding the housing can be made simpler, manufacturing cost of the mold can be reduced.

According to the present invention, the inner mounted component is inserted through the outside surface opening of the housing to be mounted, and the outside surface opening is then closed with the sheet-shaped member so that the portable electronic device can be assembled. Accordingly, the number of process steps for assembling the portable electronic device can be decreased.

### Brief Description of Drawings

FIG. 1 A is a perspective view showing an outer shape of a mobile phone representing an embodiment of the present invention;
FIG. 1B is a side view showing an outer shape of the mobile phone representing the embodiment of the present invention;
FIG. 2A is a cross sectional view taken by cutting an operator of the mobile phone along the A-A' line in FIG. 1B;
FIG. 2B is a cross sectional view taken by cutting the operator of the mobile phone along the B-B' line in FIG. 1B;
FIG. 3 is a cross sectional view showing a modified example of the mobile phone, and is a view taken by cutting the operator at the same position as in FIG. 2A;
FIG. 4 is a cross sectional view showing another modified example of the mobile phone, and is a view taken by cutting the operator at the same position as in FIG. 2B;
FIG. 5 is a cross sectional view showing still another modified example of the mobile phone, and is a view taken by cutting the operator at the same position as in FIG. 2A;
FIG. 6A is a side view showing an outer shape of yet another modified example of the mobile phone; and
FIG. 6B shows yet another modified example of the mobile phone, and is a cross sectional view taken by cutting along the C-C' line in FIG. 6A.

### Mode for Carrying Out the Invention

In the following, embodiments of the present invention will be described with reference to the drawings.

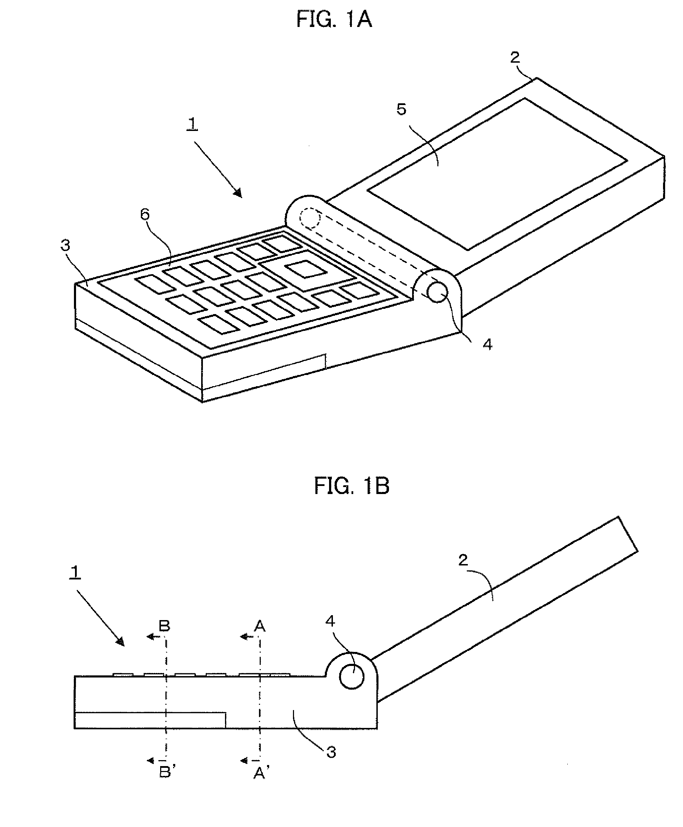

A mobile phone 1 illustrated in FIG. 1 is a portable electronic device representing an embodiment of the present invention, and is what is called a folding type of mobile phone terminal including a display 2 and an operator 3. The display 2 and the operator 3 are connected to each other via a pivot 4. The display 2 is a module that includes a liquid crystal display 5 displaying characters, diagrams, and images to show various types of information to a user. The operator 3 is a module that includes operational input keys 6 to enable a user to perform various operational input to the mobile phone 1.

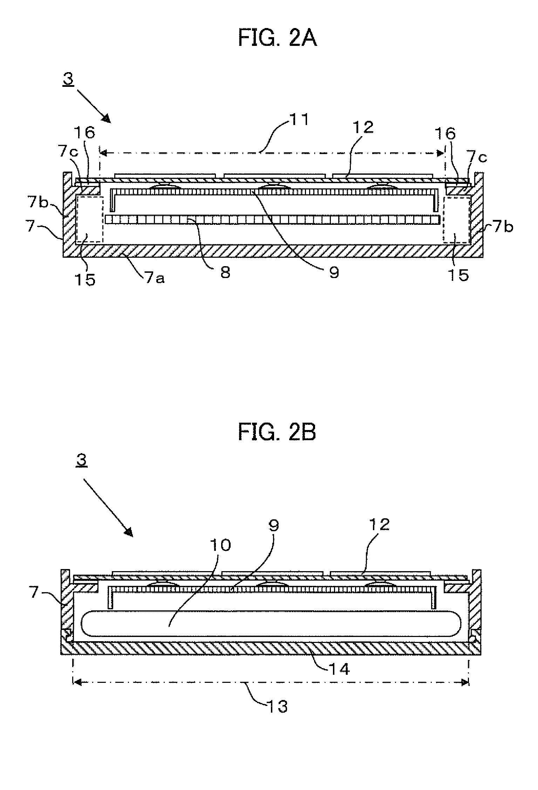

FIG. 2A is a sectional view of the operator 3 of the mobile phone 1, and is the view taken by cutting the operator 3 along the line A-A' (refer to FIG. 1B). Similarly, FIG. 2B is a view taken by cutting along the line B-B'. As illustrated in FIG. 2A and FIG. 2B, mounted inside a housing 7 of the operator 3 are a circuit board 8, a key switch board 9, and a battery 10. A part of an upper surface of the housing 7 is cut out and made open to form an upper surface opening 11. The upper surface opening 11 is covered with and closed by a key sheet 12. As illustrated in FIG. 2B, a part of a bottom surface of the housing 7 below the battery 10 is cut out and made open to form a bottom surface opening 13. The bottom surface opening 13 is covered with a battery cover 14. In the housing 7 and the battery cover 14, structures having groove shapes are formed, so that the groove shapes engage with each other. Thereby, the battery cover14 is fixed to the housing 7. Sliding the battery cover 14 along the groove shapes enables the battery cover 14 to be detached from the housing 7.

The housing 7 corresponds to a structural body that forms an outer shell of the operator 3, that is, corresponds to a housing body. As apparent from FIG. 2A and FIG. 2B, the housing 7 continuously extends from the upper surface (the surface to which the key sheet 12 is attached) to the bottom surface (the surface opposite to the upper surface) so as to be integrally structured. In other words, an upper housing part and a lower housing part of the housing 7 are integrally structured. More specifically, a shape of the cross-sectional surface of the housing 7 is formed by the bottom surface 7a, side surfaces 7b that continuously extend from both end portions of the bottom surfaces 7a, and overhang portions 7c that continuously extend from upper end portions of the side surfaces 7b and that form a part of the upper surface. The upper surface opening 11 is formed between the right and left overhang portions 7c.

Thus, the shape of the cross sectional surface of the housing 7 is C-shaped as a whole, so that the housing 7 has high flexural rigidity. Particularly, the overhang portions 7c largely contribute to the flexural rigidity of the housing 7.

A material of the housing 7 is a synthetic resin (for example, an ABS resin), and is molded by injection molding. A mold used in the injection molding includes slide pieces (not illustrated) to mold spaces 15 surrounded by the bottom surface 7a, the side surfaces 7b, and the overhang portions 7c. The slide pieces are slidably attached to the mold. Accordingly, after the spaces 15 are molded, the slide pieces move to the directions of being separated from the side surfaces 7b to be pulled out upwards via the upper opening 11. Thus, the slide pieces do not interfere with the overhang portions 7c. Providing the mold with the slide pieces enables thicknesses of portions having the side surfaces 7b to be freely designed. Accordingly, the thicknesses of the portions having the side surfaces 7b can be determined such that a sink mark (recess) is not formed at the time of molding.

The circuit board 8 is a printed circuit board in which an electronic circuit required for the mobile phone 1 is formed. The battery 10 is a secondary battery that supplies electric power to the mobile phone 1.

The key switch board 9 is a printed circuit board that is combined with the key sheet 12 to constitute the operational input keys 6, and the key switch board 9 includes a pressure sensitive sensor. In other words, when the key sheet 12 is pressed, the pressure sensitive sensor of the key switch board 9 detects that the key sheet 12 is pressed. Thereby, operational input is performed.

The key sheet 12 is a sheet formed of a material such as silicon rubber and fluoro rubber, and has appropriate flexibility. In other words, the key sheet 12 is a sheet having flexibility such that applying pressing force to the key sheet 12 causes the key sheet 12 to be deformed so that the pressing force can be transmitted to the pressure sensitive sensor on the key switch board 9, and such that when pressing force is not applied to the key sheet 12, a shape of the key sheet 12 is maintained to be a predetermined shape. As a material of the key sheet 12, a waterproof material is selected. On a surface of the key sheet 12, diagrams or characters are displayed. When a region in the key sheet 12 where the specific diagram or character is displayed is pressed, operational input corresponding to the diagram or the character is performed.

The key sheet 12 is bonded and fixed to the overhang portions 7c forming the upper surface of the housing 7. Preferably, an adhesive that exhibits a sufficient watertight property after the adhesive is hardened is selected as an adhesive 16 for bonding the key sheet 12 to the housing 7. With such a structure, the upper surface opening 11 of the housing 7 is closed by the key sheet 12 so as to be watertight.

The structure of the operator 3 was described above. However, the operator 3 may be structured as described below.

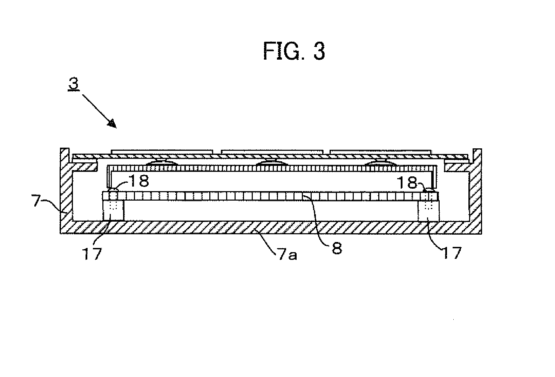

For example, inside the housing 7, screw bosses 17 protrude from the bottom surface 7a, and screws 18 are screwed into the screw bosses 17, as illustrated in FIG. 3,. Thereby, the circuit borad 8 is fixed to the housing 7. The screw bosses 17 are molded independently of a main body of the housing 7, that is, independently of a part of the housing 7 other than the screw bosses 17, and then, the after-molded screw bosses 17 are welded to be fixed to the bottom surface 7a of the housing 7. This is because if it is attempted to mold the screw bosses 17 at the same time that the main body of the housing 7 is molded, the above-described slide pieces interfere with the screw bosses 17. In other words, this is because otherwise the spaces 15 (refer to FIG. 2) cannot be formed.

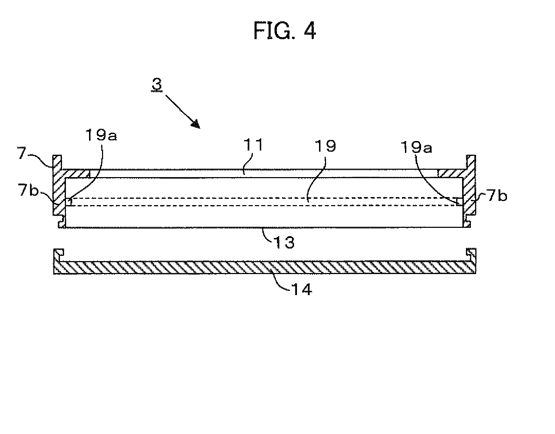

According to the mobile phone having the cross section illustrated in FIG. 2B, it is possibly difficult to detach the housing 7 from the mold since an appropriate portion against which an injection pin (not illustrated) is pressed does not exist, the injection pin being used for pushing out the housing 7 from the mold (not illustrated). In view of such matter, as illustrated in FIG. 4, a dummy rib 19 may be formed between the upper surface opening 11 and the bottom surface opening 13 so that injection pin can be pressed against the dummy rib 19. Both ends of the dummy rib 19 are joined to the side surfaces 7b of the housing 7. After the housing 7 is detached from the mold to the outside thereof, a part of the dummy rib 19 is cut out and removed, the part being illustrated by the dashed line. It becomes unnecessary to perform a finishing process (for example, a grinding process) so as to remove cut remaining portions 19a if the housing 7 is designed by taking into account sizes of the cut remaining portions 19a that remain after the dashed-line part of the dummy rib 19 is cut out and removed, that is, if the housing 7 is designed such that an appropriate volume inside the housing 7 is secured even if the cut remaining portions 19b exist.

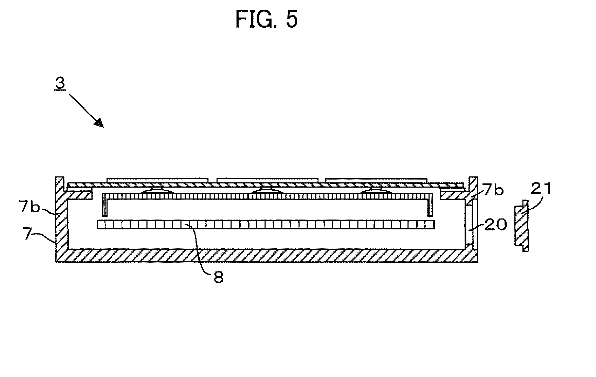

As illustrated in FIG. 5, a part of the side surface 7b of the housing 7 may be cut and made open to form a side surface opening 20. For example, the side surface opening 20 is an opening through which a cable (not illustrated) or the like passes, the cable being connected to an external interface (not illustrated) on the circuit board 8 (refer to FIG. 2A). When the cable or the like does not pass through the side surface opening 20, the side surface opening 20 is closed by a blind cover 21. The side surface 7b is a region where a sink mark (recess) is easily generated when the housing 7 is molded. When such a region has the side surface opening 20, a sink mark (recess) is not generated in the region. As a result, appearance of the housing 7 is improved.

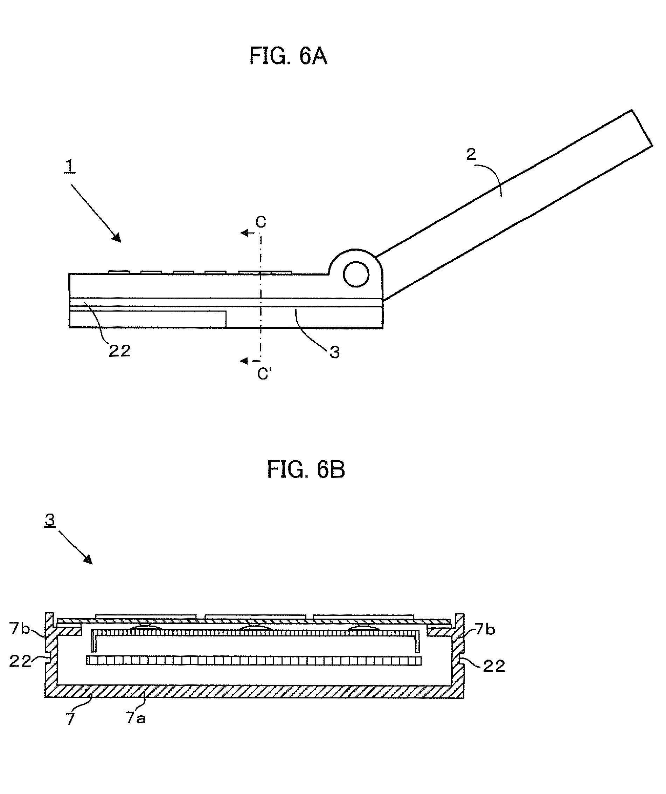

As illustrated in FIG. 6A and FIG. 6B, grooves 22 may be formed in the side surfaces 7b of the housing 7. Providing the grooves 22 visually divides a height of the side surfaces 7b, that is, divides a thickness of the housing 7. As a result, the housing 7 looks thin.

As described above, according to the present invention, a coupling that can be separated does not exist between the upper housing part and the lower housing part of the housing for the portable electronic device. Accordingly, a waterproof property of the portable electronic device can be improved. Through the upper surface opening formed in the upper surface of the housing, the inner mounted components are inserted and mounted inside the housing, and the upper surface opening can be then closed by the sheet-shaped member. Accordingly, it becomes easier to assemble the portable electric device.

The concrete embodiments of the present invention were described by taking the mobile phone 1 as an example. These embodiments are examples, and do not limit the technical scope of the present invention. The present invention can be embodied by free practical application, modification, or improvement within the scope of the technical idea described in the claims.

For example, in the above-described embodiments, the injection molding performed with the synthetic resin to form the housing 7 was exemplified. However, the housing according to the present invention is not limited to the housing formed by the injection molding. Various types of processing means and processing methods can be selected for manufacturing the housing according to the present invention. Since the synthetic resin transmits an electromagnetic wave, the synthetic resin is an optimum material for the housing for the mobile phone. When transmissivity to an electromagnetic wave is not required, a material of the housing is not limited to the synthetic resin. For example, a material of the housing may be one of various types of metals, or may be a composite material made by compounding a resin and a metal.

The term "the upper housing part and the lower housing part are integrally combined to form the housing" means that the upper housing part and the lower housing part are combined with each other in a state where the upper housing part and the lower housing part cannot be separated from each other, or means that a freely separatable coupling does not exist between the upper housing part and the lower housing part. For the housing, it suffices that the upper housing part and the lower housing part are integrally structured at the time of completion of the housing, and in the middle of the process of manufacturing the housing, the upper housing part and the lower housing part may be separated from each other. For example, the technical scope of the present invention includes the housing that is manufactured by molding the upper housing part and the lower housing part independently of each other, and then bonding the upper housing part and the lower housing part by means of using an adhesive, melting or the like such that the upper housing part and the lower housing part cannot be separated from each other.

In the above-described embodiments, an example in which the opening is provided at a part of the housing was described, that is, an example in which the upper surface opening 11, the bottom surface opening 13, or the side surface opening 20 is provided in the housing was described. However, a part or all of these openings may be omitted. Alternatively, another opening may be additionally provided.

In the above-described embodiments, as an example of the housing according to the present invention, the housing 7 forming the outer shell of the operator 3 of the mobile phone 1 was exemplified. However, application of the present invention is not limited to the housing 7, and the present invention can be applied to an outer shell of the display 2 of the poratble telephone 1.

In the above-described embodiments, what is called the folding type of the mobile phone terminal (portable telephone 1) was exemplified. However, the mobile phone terminal to which the present invention is applied is not limitd to the folding type. The mobile phone terminal may be what is called an integrated type in which the operator and the display are disposed in a single housing. The mobile phone terminal may be what is called two-pivot hinge type of the mobile phone terminal that includes not only a folding hinge pivot, but also a reversing hinge pivot that is perpendicular to the folding hinge pivot so that the display can rotate around the reversing hinge pivot.

Application of the present invention is not limited to the mobile phone terminal. The present invention can be widely applied to housings of various types of portable electronic devices such as a mobile phone, a personal digital assistant, an electronic dictionary, an electronic organizer, an electronic book, a calculator, and a portable personal computer.

In the above-described embodiments, as examples of the inner mounted components, the circuit board 8, the key switch board 9, and the battery 10 were exemplified. However, these components are examples, and application of the present invention is not limited to the portable electronic device in which these components are mounted. In short, the inner mounted component is a component that is mounted inside the housing and that constitutes the portable electronic device. The inner mounted component may have any name and any function.

In the above-described embodiments, as an example of an outside surface opening, the upper surface opening 11 was exemplified. However, the outside surface opening is not limited to the opening formed in the upper surface of the housing. The outside surface opening may be formed in the bottom surface or the side surface of the housing, and may be closed by the sheet-shaped member. For example, the outside surface opening may be the bottom surface opening 13 or the side surface opening 20.

For describing the cross sectional shape (refer to FIG. 2A and FIG. 2B) of the housing 7, the term "upper surface" and the term "bottom surface" were used. However, these terms were used for convenience, and the term "upper surafce" does not always means a surface that is positioned above the bottom surface. This applies to interpretation of the technical scope of the present invention, as well. For example, a structure formed by turning the structure of FIG. 2A and FIG. 2B upside down may be selected, that is, a structure in which the overhang portions are positioned below the bottom surface may be selected. In short, it suffices that the cross sectional shape of the housing is C-shaped as a whole. The C-shape may be directed upward, downward, rightward, or leftward.

In the above-described embodiments, as an example of the sheet-shaped member, the key sheet 12 was exemplified. However, the sheet-shaped member that constitutes the present invention is not limited to the key sheet 12. It suffices that the sheet-shaped member has a flat shape that can cover and close the opening (upper surface opening 11) provided in the housing. Other functions are not essential for the sheet-shaped member. The sheet-shaped member may be flexible, or may be rigid. The housing to which the sheet-shaped member is attached is not limited to the operator 3. For example, when the opening is provided in the display 2, and this opening is covered with the liquid crystal display 5, the liquid crystal display 5 functions as the sheet-shaped member that constitutes the present invention. It suffices that the sheet-shaped member has an approximately flat shape as a whole. The sheet-shaped member may have some unevenness, that is, may have smaller unevenness compared with a size of the flat shape. For example, on a surface of the key sheet 12, a convex portion imitating a mechanical button switch may be provided, or a character or/and a diagram may be expressed by unevenness.

Shapes and sizes of the mobile phone 1 illustrated in the drawings are examples. The drawings naturally express a concept of a mechanical structure of the mobile phone 1, and do not precisely express shapes and sizes of the actual mobile phone 1. Accordingly, the technical scope of the present invention is not limited by these shapes and sizes.

A part or all of the above-described embodiments can be described as in the following additional notes, as well. However, the present invention is not limited to the following.

### (Note 1)

A housing for a portable electronic device including an upper housing part and a lower housing part,
wherein an upper-side bottom surface opening formed in a lower surface of the upper housing part is integrally combined with a lower-side upper surface opening formed in an upper surface of the lower housing part to form the housing.

### (Note 2)

The housing for the portable electronic device according to Note 1,
wherein a cross section of the housing includes a rectangular bottom surface that forms a portion of the lower housing part, a pair of rectangular side surfaces that are arranged respectively at two facing-each-other sides of the bottom surface and that extend continuously from the bottom surface, and a pair of overhang portions that are arranged respectively at sides included in the pair of side surfaces and facing sides included in the pair of side surfaces and extended continuously from the bottom surface and that extends continuously from the pair of side surfaces and that forms a portion of the upper housing part, and
an upper surface opening is formed between the overhang portions.

### (Note 3)

The housing for the portable electronic device according to Note 2, including a protruding portion that rises from the bottom surface and that is formed after the upper housing part and the lower housing part are integrally combined to form the housing.

### (Note 4)

The housing for the portable electronic device according to Note 2 or 3,
wherein an upper-side upper surface opening is formed in an upper surface of the upper housing part so as to face the upper-side bottom surface opening,
the housing includes cut remaining portions of a dummy rib that are provided at the pair of side surfaces and that are positioned between the upper-side upper opening and the upper-side bottom surface opening, and
the cut remaining portions are portions that remain in the dummy rib that connected the pair of side surfaces and that were cut and removed after the housing is molded.

### (Note 5)

A portable electronic device including the housing according to any of Notes 1 to 4, and an inner mounted component arranged inside the housing.

### (Note 6)

A portable electronic device including:
the housing according to any of Notes 1 to 4;
an outside surface opening that is formed in at least a part of outside surfaces of the housing, and through which an inner mounted component is inserted; and
a sheet-shaped member that covers the outside surface opening.

### (Note 7)

The portable electronic device according to Note 6,
wherein the sheet-shaped member is bonded to the housing to watertightly close the outside surface opening.

### (Note 8)

A method for assembling a portable electronic device, including:
fitting and integrally combining an upper-side bottom surface opening formed in a lower surface of an upper housing part with a lower-side upper surface opening formed in an upper surface of a lower housing part to form a housing;
forming an outside surface opening that opens at least a part of outside surfaces of the housing;
inserting an inner mounted component through the outside surface opening into an inside of the housing to mount the inner mounted component; and
covering the outside surface opening with a sheet-shaped member.

### (Note 9)

The method for assembling the portable electronic device according to Note 8, further including:
bonding the sheet-shaped member to the housing to watertightly close the outside surface opening.

The present invention is based upon Japanese Patent Application No. 2010-241213, filed on October 27, 2010. The entire contents of the specification, the claims, and the drawings of Japanese Patent Application No. 2010-241213 are incorporated herein by reference.

### Description of Reference Numerals

- 1: Mobile phone
- 2: Display
- 3: Operator
- 4: Pivot
- 5: Liquid crystal display
- 6: Operational input keys
- 7: Housing
- 8: Circuit board
- 9: Key switch board
- 10: Battery
- 11: Upper surface opening
- 12: Key sheet
- 13: Bottom surface opening
- 14: Battery cover
- 15: Space
- 16: Adhesive
- 17: Screw boss
- 18: Screw
- 19: Dummy rib
- 20: Side surface opening
- 21: Blind cover
- 22: Groove

## Claims

1. A housing for a portable electronic device comprising an upper housing part and a lower housing part,
wherein an upper-side bottom surface opening formed in a lower surface of the upper housing part is integrally combined with a lower-side upper surface opening formed in an upper surface of the lower housing part to form the housing.

2. The housing for the portable electronic device according to Claim 1,
wherein a cross section of the housing comprises a rectangular bottom surface that forms a portion of the lower housing part, a pair of rectangular side surfaces that are arranged respectively at two facing-each-other sides of the bottom surface and that extend continuously from the bottom surface, and a pair of overhang portions that are arranged respectively at sides included in the pair of side surfaces and facing sides included in the pair of side surfaces and extended continuously from the bottom surface and that extends continuously from the pair of side surfaces and that forms a portion of the upper housing part, and
an upper surface opening is formed between the overhang portions.

3. The housing for the portable electronic device according to Claim 2, comprising a protruding portion that rises from the bottom surface and that is formed after the upper housing part and the lower housing part are integrally combined to form the housing.

4. The housing for the portable electronic device according to Claim 2 or 3,
wherein an upper-side upper surface opening is formed in an upper surface of the upper housing part so as to face the upper-side bottom surface opening,
the housing comprises cut remaining portions of a dummy rib that are provided at the pair of side surfaces and that are positioned between the upper-side upper opening and the upper-side bottom surface opening, and
the cut remaining portions are portions that remain in the dummy rib that connected the pair of side surfaces and that were cut and removed after the housing is molded.

5. A portable electronic device comprising the housing according to any of Claims 1 to 4, and an inner mounted component arranged inside the housing.

6. A portable electronic device comprising:
the housing according to any of Claims 1 to 4;
an outside surface opening that is formed in at least a part of outside surfaces of the housing, and through which an inner mounted component is inserted; and
a sheet-shaped member that covers the outside surface opening.

7. The portable electronic device according to Claim 6,
wherein the sheet-shaped member is bonded to the housing to watertightly close the outside surface opening.

8. A method for assembling a portable electronic device, comprising:
fitting and integrally combining an upper-side bottom surface opening formed in a lower surface of an upper housing part with a lower-side upper surface opening formed in an upper surface of a lower housing part to form a housing;
forming an outside surface opening that opens at least a part of outside surfaces of the housing;
inserting an inner mounted component through the outside surface opening into an inside of the housing to mount the inner mounted component; and
covering the outside surface opening with a sheet-shaped member.

9. The method for assembling the portable electronic device according to Claim 8, further comprising:
bonding the sheet-shaped member to the housing to watertightly close the outside surface opening.
